# EUROPEAN PATENT SPECIFICATION

(11) **EP 2 536 869 B1**
(45) Date of publication and mention of the grant of the patent: **08.01.2014**
(21) Application number: 11707362.7
(22) Date of filing: 15.02.2011
(51) Int. Cl.: C23C 16/455, C23C 16/44

(54) **CONSTANT VOLUME CLOSURE VALVE FOR VAPOR PHASE DEPOSITION SOURCE**
VENTILVERSCHLUSS MIT KONSTANTEM VOLUMEN FÜR EINE AUFDAMPFQUELLE
VANNE D'OBTURATION A VOLUME CONSTANT D'UNE SOURCE DE DEPOT EN PHASE VAPEUR

(30) Priority: 18.02.2010 US 305606 P; 16.02.2010 FR 1051100
(43) Date of publication of application: 26.12.2012
(73) Proprietor: Astron Fiamm Safety, 83077 Toulon (FR)
(72) Inventor: DUSSERT-VIDALET, Bruno, 83100 Toulon (FR); GUERARD, Cédric, F-83400 Hyeres (FR)
(74) Representative: Decobert, Jean-Pascal
(86) International application number: PCT/EP2011/052173
(87) International publication number: WO 2011/101326

(56) References cited:
- EP-A1- 0 989 200
- WO-A2-2004/007793
- WO-A2-2004/050938
- GB-A- 2 342 929
- US-A- 3 058 842
- US-A- 5 431 735
- US-A1- 2005 061 244
- US-A1- 2007 089 676
- US-B1- 6 830 626

## Description

### TECHNICAL FIELD OF THE INVENTION

The general field of the present invention concerns the vapor deposition of materials in the micro-electronics industry. More especially, it addresses the creation of vapor sources to enable continuous deposition on large surfaces that can be interrupted without inconvenience.

### STATE OF THE TECHNIQUE

The ever-increasing number of electronic and optical components and their integration within a same device has led to the development of sophisticated techniques for depositing various materials, on a substrate to form the thin layers that constitute these devices.

Vapor-phase deposition covers a very broad range of processes, especially those described as vapor-phase chemical deposition, and generally designated by their English acronym of CVPD, "chemical vapor-phase deposition". As the name suggests, this type of deposition involves a chemical reaction occurring during the operation by, for instance, prior introduction of a precursory gas into the deposition chamber or by a chemical reaction taking place with a layer of a material that has already been deposited on the substrate, and even with the substrate itself. Other types of chemical vapor-phase depositions do not involve such chemical reactions. These consist of simple physical deposition by evaporation in a controlled neutral atmosphere and/or in more or less vacuum conditions.

All the vapor-phase deposition techniques require a mechanical device in order to create in the deposition chamber the source of the evaporated material to be deposited. This is always a critical factor to be applied in order to obtain a uniform thickness of the thin layers deposited and good control over their physico-chemical characteristics. It is becoming increasingly difficult to create the source as the mass production, at low cost, of electronic and optical devices requires that the substrates on which they are applied become increasingly large in size in order to produce an increasing number of devices, or increasingly large devices, during the same production cycle. Therefore, it is not surprising that a source that allows continuous vapor-phase deposition of various materials over widths that may be measured in tens of centimeters, even around one meter, is required. Moreover, the industrial production of such devices implies that deposition can be interrupted and restarted at will without damage to the source and the evaporated material.

This facilitates a certain flexibility in the deposition of different films for different devices, without changing the configuration of the chamber.

Although the micro-electronics industry has for a long time been faced with the need to deposit materials such as dielectrics or metals, the manufacture of electroluminescent devices such as displays and screens containing organic electroluminescent diodes (OLEDs) requires recourse to the deposition of much more fragile organic materials.

Evaporation from a linear source of broad widths of organic material raises the critical problem of the temperature variation that has to be observed between the point of vapor creation and the points of its diffusion, i.e. nozzles installed over the full width of the source, in the deposition chamber. Indeed, to avoid the condensation of material on the walls of the tubes transporting the vapor and on those of the diffuser constituting the source, it is an advantage to be able to maintain a temperature gradient that is always positive in order to prevent any cold zones bringing the temperature of the gas to below its dewpoint. This is all the more difficult to carry out in that, as is the case for organic materials, the destruction temperature of the material to be deposited is close to its evaporation temperature. Moreover, very broad linear sources consisting of multiple chambers are more sensitive than the point sources since it is necessary to monitor this slight gradient over all the diffuser surface, from the evaporation crucible up to each nozzle.

Linear sources are the subject of great interest, in particular for their capacity to achieve high speeds deposition. They also ensure efficient use of the material mainly, due to the source-substrate distance which is much smaller than with a point source. The presence of multiple nozzles and their design, that is intended to ensure uniform deposits over a large surface, is a major asset which makes their use essential for the large-scale production of devices such as the electroluminescent devices mentioned above. However this short distance, combined with a high speed of evaporation, makes the conventional closing systems (which stop the process of deposition on the substrate) difficult to carry out for mechanical reasons. In addition, they are not easy to use due to the speed with which they are become clogged. Therefore, sources equipped with a valve making it possible to close the vapor transport tube in order to interrupt its diffusion towards the substrate and not to waste the material to be evaporated. When closed, the valve then greatly reduce the volume of the pipe connected to the point at which the vapor is created. This significant reduction of the volume produces a sharp variation of the vapor generation system load, which increase the pressure in the steam creation zone very significantly. This strong pressure variation then causes a rise in the temperature until saturation of the vapor creation zone. This rise in temperature will in turn create thermal degradation of the material to be deposited.

Therefore, it is a general aim of the invention to overcome at least in part one of the shortcomings described above found in the linear sources used in vapor-phase deposition systems that are required to operate continuously with deposition stopping and restarting phases. It is also an aim of the invention to describe an advantageously linear source that enables the deposition of organic materials whose destruction temperature is close to the evaporation temperature.

Other aims, characteristics and advantages of this invention will become clear on examination of the following description and the accompanying drawings. It is understood that other advantages may be incorporated.

### SUMMARY OF THE INVENTION

To achieve these aims, the invention describes a source for phase-phase deposition of a material. This consists of a vessel divided into two zones. The first zone is a zone generating the vapor. It is equipped with a receptacle for the material and means for heating the material placed in the receptacle. The second is a diffusion zone communicating with the production zone. It is equipped with at least one orifice so that the material in vapor phase is transmitted towards the exterior of the vessel through this orifice. The source is characterized in that it includes means for closing the orifice and means for moving the means for closing between an active closed position and an orifice open position.

The invention also include the following features:
- It comprises orifices in the form of vapor nozzles.
- The diffusion zone comprises a diffuser with cylindrical body on which the diffusion nozzles are positioned side by side.
- The means for closing comprise a cylindrical sleeve in contact with the inner face of the diffuser, the cylindrical sleeve comprising on the one hand several openings capable of being positioned opposite several diffusion nozzles in the open position and moreover, an opening opposite the steam production zone.

The invention may also include the following features:
- The cylindrical sleeve is configured to move inside the diffuser in order to close the series of diffusion nozzles while keeping opened the vapor production zone.
- Means for moving the cylindrical sleeve comprising an axial rod joined to the cylindrical sleeve and accessible through the diffuser.
- Means for moving the cylindrical sleeve comprises means for rotating the axial rod.
- The means for moving the cylindrical sleeve include lateral translation means operated by the axial rod.
- The diffuser includes at least one nozzle opened separately from the movement of the cylindrical sleeve.
- Here, at least one independent nozzle is placed advantageously in the axis of the diffuser at the end opposite the axial rod.
- The material receptacle is a cylindrical crucible the opening of which connected to the diffuser has a diameter that is identical to the inner diameter of the cylindrical sleeve.
- The diffusion zone and the production zone are tubular cylinders assembled to form a T, the production zone of which is the branch centered on the branch forming the diffuser.
- The means for closing are configured in order to maintain the diffusion zone in connection with the production zone when the orifice is in the open position.

### BRIEF DESCRIPTION OF THE FIGURES

The aims, purposes, characteristics and advantages of the invention will be better understood from the detailed description of its embodiment which is shown on the following accompanying drawings on which:
Figures 1A and 1 B illustrate the linear vapor-phase deposition source according to the invention in which the valve closing the nozzles consists of a rotary sleeve.
Figures 2A and 2B show a variant of the linear vapor-phase deposition source according to the invention in which the valve closing the nozzles consists of a sliding sleeve.

The attached drawings are given as examples and are not restrictive.

### DETAILED DESCRIPTION OF THE INVENTION

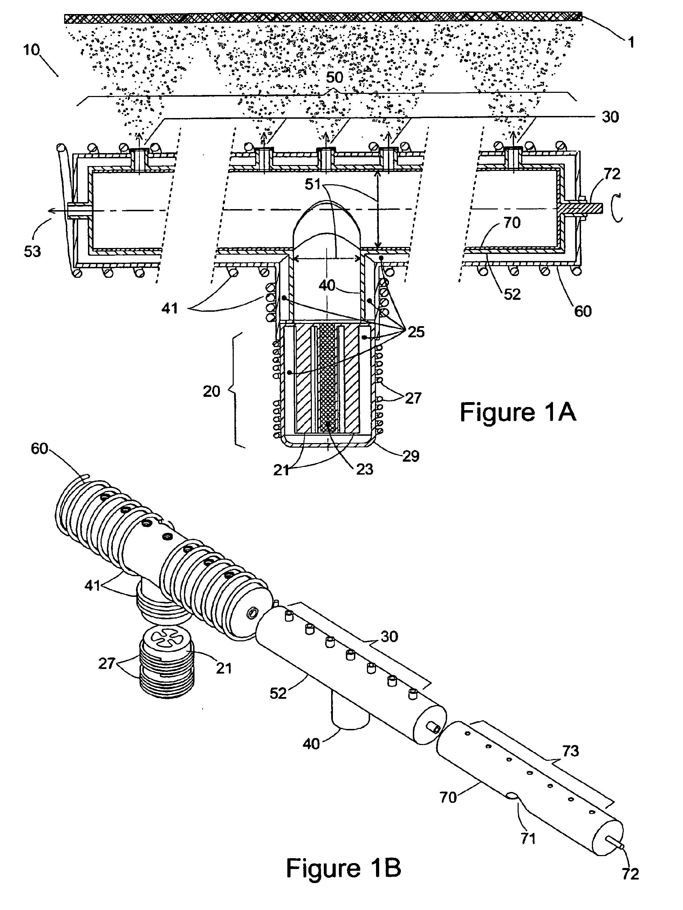

**Figures 1A and 1B** illustrate a linear source of vapor-phase deposition according to the invention in which the nozzle closure valve consists of a rotary sleeve.

The term linear means a source with several nozzles (the preferred embodiment of the invention), the nozzles being placed next to one another according to one dimension of the source. Preferably, this juxtaposition consists of one straight alignment of the nozzles, but this is not restrictive.

The invention describes how, in a preferred embodiment, a linear vapor-phase deposition source 10 makes it possible to obtain a very flat temperature gradient between material furnace 20 (situated in a vapor production zone) and evaporation nozzles 30 situated in a diffusion zone. Furnace crucible 21 contains material 23 that is to be evaporated, for instance an organic material of the type used to manufacture electroluminescent diodes.

To avoid any break in the load when the vapor is transmitted to the nozzles, the vertical vapor injection pipe 40 from the crucible and the internal part of horizontal diffuser 50 form a T assembly with identical diameters 51. This diameter is typically around 40 to 50 mm. The width of diffuser 50 has to be compatible with the size of substrate 1 on which the deposit is to be made. Typically, several tens of centimeters, and even more, may be deposited on the substrate. Maintaining a constant diameter between the crucible, the vertical vapor injection pipe and the diffuser guides it so that it is injected through nozzles into the evaporation chamber, at the same time minimizing the required temperature gradient. This constant diameter concept minimizes the overpressures and therefore the heating of the vapor it encounters. The temperature gradient guarantees the progression and the acceleration of the vapor up to the outlet nozzles.

Crucible 21, vertical pipe 40 and diffuser 50 bathe in a heat-transporting liquid 25 found between crucible 21 and its envelope 29, and in all the annular space between on the one hand vertical pipe 40 and inner wall 52 of diffuser 50, and on the other, an outer tubular envelope 60 with T-shape whose branches are respectively coaxial with the vertical pipe and the horizontal diffuser. In this arrangement of the invention, heating filaments 27 and 41 surround the outer tubular envelopes in order to indirectly heat crucible 21, vertical pipe 40 and diffuser 50 by the use of a heat-transporting fluid. This ensures that there is excellent distribution of the heat over all the surfaces in contact with on the one hand the material to be evaporated in the heating furnace, and on the other with the vapor in pipe 40 and diffuser 50.

The terms "vertical" and "horizontal" mean substantially the orientation of the invention components in a preferred position of use with the vapor diffusing substantially in a vertical direction.

For the linear source of the invention to be used for continuous industrial production, means have to be provided for stopping and restarting the process of evaporation without damaging the materials to be evaporated. The purpose of the invention is achieved in this first implementation of the invention by placing a vapor check valve in the diffuser in the form of a sleeve 70 with a diameter that corresponds to the inner diameter of the diffuser and which can be turned using an axial mechanical control using rod 72. In a preferred embodiment, sleeve 70 is a hollow cylindrical body with circular section that coacts with a diffuser 50 of the same shape and constitutes a space inside diffuser 50 capable of varying the configuration of the diffusion zone between an open position of the orifices and closed position. Orifices 73 are drilled at the position of the nozzles so that the steam can pass through during deposition. Simple rotation of the sleeve is sufficient to mask the nozzles and interrupt the deposition process. It will be observed that this takes place without changing the inner volumes of the source. Lower orifice 71, which is positioned opposite vapor injection pipe 40, is such that when rotated to mask the nozzles, the latter do not obstruct the vapor injection pipe.

Therefore rotary sleeve 70 makes it possible to rapidly cut off the evaporation while ensuring that the source remains ready to restart. Closing the source at the level of the nozzles, which is the last point for containing the vapor without this varying the volume of the vapor creation system load, has only a very slight impact on the vapor source and no increase in its temperature is observed during steam saturation. This closure system therefore enables the evaporation to be cut off without consuming the material.

In order to help maintain the thermodynamic balance of the source, the system for measuring the rate of deposition, which is placed preferably in the axis of the diffuser in order not to disturb the evaporation flux from the source towards the substrate, remains active. This nozzle is used to measure the rate of deposition and therefore to guarantee a rate that is close to the required rate during the source closure phase in order to minimize the stabilization time after reopening the closure system. During closure of the deposition nozzles, nozzle 53, which is dedicated to the measurement function (the measurement part is not shown on the drawing), is placed in the diffuser axis and remains open in order to minimize the pressure. This also maintains a stable flux throughout the closure period and therefore achieves greater reactivity by reducing the time required to stabilize the flux once the steam closure valve (that is to say the rotary sleeve used to close the nozzles) is once again open in order to continue one deposition or to make another.

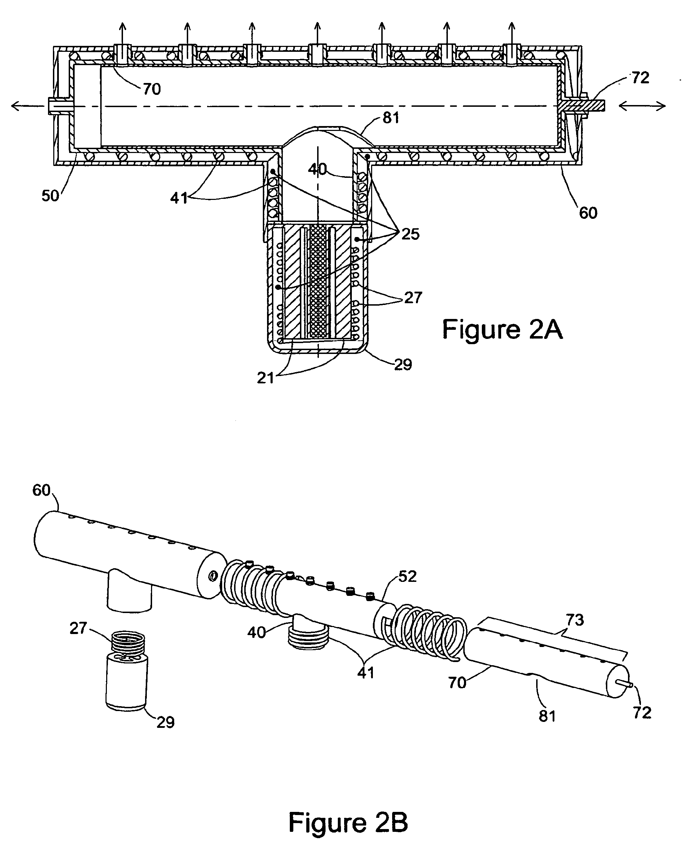

**Figures 2A and 2B** show a variant to the vapor-phase linear deposition source according to the invention in which the nozzle closure valve consists of a sliding sleeve.

In this second application of the invention, rotary sleeve 70 is replaced by a sliding sleeve 70. As this is a little shorter than diffuser 50, closure of the nozzles is this time achieved by lateral movement of the sliding sleeve using axial control 82, identical to the previous one. As previously, openings 83 are drilled at the position of the nozzles in order to allow the vapor to pass through during the deposition phase. Here again, deposition is stopped without changing the source inner volumes. Lower orifice 81, which is positioned opposite vapor vertical injection pipe 40, has a shape and dimensions such that the lateral displacement in order to mask the nozzles does not obstruct vapor pipe 40 in any way.

Figures 2A and 2B also show that heating filaments can be placed in the annular space containing heat transporting fluid 25. Immersed in the heat transporting fluid, filaments 27 and 41 apply heat directly, thereby ensuring that the temperatures are uniform. This concerns both filaments 27 that are used to heat crucible 21 and filaments 41 that are used to maintain the temperature gradient around vertical pipe 40 of diffuser 50.

Of course, the embodiment options illustrated on figures 1 A, 1 B and 2A, 2B can be combined without any inconvenience. Filaments 27 and 41 may be placed in the coolant fluid and this may be combined with the use of rotary sleeve 70. The opposite is also possible (sliding sleeve and heating elements around the envelopes). Moreover, the use of a rotary sleeve 70 or a laterally moving sleeve 70 can also be envisaged with any other heating device while retaining the advantage provided by this type of nozzle closure device that takes place without changing the volume of diffuser 50. As previously explained, this helps to avoiding deterioration and loss of costly material in crucible 21 during the phases when deposition has to be stopped, and therefore extends the period during which the latter can be used.

The valve, whether rotary or moving laterally, can therefore be used to instantly cut off and restart the emission of this vapor in the diffusion zone while retaining the source during the evaporation phase. Closure of the diffusion nozzles alone by the valve makes it possible not to alter the volume of the load in crucible 21 and therefore minimizes the overpressure and the temperature increase which would otherwise result from closing the source at the level of the steam production zone.

Maintaining the steam flux towards the measurement system, even when the valve is closed, maintains the source flow conditions and continues to control the heating devices in order to maintain the quantity of vapor generated. This solution ensures an instantaneously stabilized source once the valve is opened.

The valve can also be interlocked and used to ensure emitted flux regulation so as to guarantee a rapid change of flux or stability of flux without temperature variations. In particular, this solution quickly smoothes out any flux variations that depend on the level of the material filling crucible 21.

## Claims

1. Deposition source (10) of a material in vapor phase comprising a vessel equipped with two zones:
a vapor production zone (20) equipped with a receptacle for the material and means for heating the material placed in the receptacle;
a diffusion zone communicating with the production zone and equipped with at least one orifice (30) so that the material in vapor phase is transmitted towards the exterior of the vessel through the orifice;
the said deposition source is **characterized by** the fact that:
- it comprises means for closing the orifice and means for moving the means for closing between an active closed position and an orifice (30) open position,
- it has a series of orifices (30) in the form of nozzles diffusing the vapor,
- the diffusion zone consists of a diffuser (50) with cylindrical body on which the diffusion nozzles are placed side by side,
- the means for closing comprise a cylindrical sleeve (70) in contact with the inner face of diffuser (50), cylindrical sleeve (70) comprising on the one hand several openings (73) capable of being positioned opposite several diffusion nozzles in the open position and, on the other, an opening opposite vapor production zone (71).

2. Deposition source according to the previous claim wherein cylindrical sleeve (70) is configured to move inside diffuser (50) in order to close the series of diffusion nozzles while keeping opened the vapor production zone (20).

3. Deposition source according to the previous claim wherein means for the movement of cylindrical sleeve (70) comprises an axial rod (72) joined to cylindrical sleeve (70) and accessible through diffuser (50).

4. Deposition source according to the previous claim wherein the means for moving cylindrical sleeve (70) comprises means for the rotation of axial rod (72).

5. Deposition source according to claim 3 wherein the means for moving cylindrical sleeve (70) comprises means for lateral translation of axial rod (72).

6. Deposition source according to any one of the previous claims wherein diffuser (50) includes at least one nozzle (53) opening separately from the movement of the cylindrical sleeve (70).

7. Deposition source according to one of claims 3 to 5 wherein at least one independent nozzle (53) is placed in the axis of diffuser (50) at the end opposite the axial rod (72).

8. Deposition source according to any one of the previous claims wherein the material receptacle consists of a cylindrical crucible (21), the opening (40) of which connecting to diffuser (50) has a diameter that is identical to the inner diameter of cylindrical sleeve (70).

9. Deposition source according to any one of the previous claims wherein the zone of diffusion and the zone of production are tubular cylinders assembled to form a T, the production zone of which is the branch centered on the branch forming diffuser (50).

10. Deposition source according to any one of the previous claims wherein the means for closing are configured to maintain the connection between the diffusion zone and the production zone when orifice (30) is open.

## Patentansprüche

1. Aufdampfquelle (10) eines Materials in der Dampfphase, umfassend einen mit zwei Bereichen ausgerüsteten Behälter:
einem Dampf produzierenden Bereich (20), der mit einer Aufnahme für das Material und Mitteln zum Heizen des in den Behälter platzierten Materials ausgerüstet ist;
einem Diffusionsbereich mit dem Produktionsbereich und der mit wenigstens einer Öffnung (30) ausgerüstet ist, so dass das Material in der Dampfphase durch die Öffnung zur Außenseite des Behälters übertragen wird;
wobei die genannte Aufdampfquelle durch die Tatsache gekennzeichnet ist, dass:
- sie Mittel zum Schließen der Öffnung und Mittel zum Bewegen der Mittel zum Schließen zwischen einer aktiven geschlossenen Position und einer offenen Öffnungsposition (30) umfasst,
- sie eine Serie von Öffnungen (30) in Form von den Dampf zerstäubenden Zerstäubern hat,
- der Diffusionsbereich aus einem Diffuser (50) mit zylindrischem Körper gebildet wird, auf dem die Diffusionszerstäuber Seite an Seite platziert sind,
- die Mittel zum Schließen einen zylindrischen Schlauch (70), der mit der inneren Seite des Diffusers (50) in Kontakt ist, einen zylindrischen Schlauch (70), der auf der einen Seite mehrere Löcher (73) umfasst, die gegenüber mehreren Diffusionszerstäubern in der offenen Position positioniert werden können, und auf der anderen Seite eine Öffnung gegenüber dem Dampf produzierenden Bereich (71) umfassen.

2. Aufdampfquelle gemäß dem voranstehenden Anspruch, bei dem der zylindrische Schlauch (70) konfiguriert ist, um sich innerhalb des Diffusers (50) zu bewegen, um die Serie der Diffusionszerstäuber zu schließen und dabei gleichzeitig den Dampf produzierenden Bereich (20) geöffnet zu halten.

3. Aufdampfquelle gemäß dem voranstehenden Anspruch, bei der das Mittel für die Bewegung des zylindrischen Schlauchs (70) einen axialen Stab (72) umfasst, der dem zylindrischen Schlauch (70) angefügt ist und durch den Diffuser (50) zugänglich ist.

4. Aufdampfquelle gemäß dem voranstehenden Anspruch, bei dem das Mittel zum Bewegen des zylindrischen Schlauchs (70) Mittel für die Rotation des axialen Stabes (72) umfasst.

5. Aufdampfquelle gemäß Anspruch 3, bei dem das Mittel zum Bewegen des zylindrischen Schlauchs (70) Mittel für die laterale Translation des axialen Stabes (72) umfasst.

6. Aufdampfquelle gemäß einem der voranstehenden Ansprüche, bei der der Diffuser (50) wenigstens einen Zerstäuber (53) umfasst, der separat von der Bewegung des zylindrischen Schlauchs (70) geöffnet wird.

7. Aufdampfquelle gemäß Anspruch 3 bis 5, bei der wenigstens ein unabhängiger Zerstäuber (53) in der Achse des Diffusers (50) am gegenüberliegenden Ende des axialen Stabes (72) platziert ist.

8. Aufdampfquelle gemäß einem der voranstehenden Ansprüche, bei dem die Materialaufnahme aus einem zylindrischen Tiegel (21) gebildet ist, dessen den Diffuser (40) anschließender Eingang einen Durchmesser hat, der mit dem Innendurchmesser des zylindrischen Schlauchs (70) identisch ist.

9. Aufdampfquelle gemäß einem der voranstehenden Ansprüche, bei der der Diffusionsbereich und der Produktionsbereich röhrenförmige Zylinder sind, die in Form eines Ts montiert sind, dessen Produktionsbereich der Zweig ist, der auf dem der den Diffuser (50) bildende Zweig zentriert ist.

10. Aufdampfquelle gemäß einem der voranstehenden Ansprüche, bei der die Mittel zum Schließen den Anschluss zwischen dem Diffusionsbereich und dem Produktionsbereich beibehalten, wenn die Öffnung (30) offen ist.

## Revendications

1. Source de dépôt (10) d'un matériau en phase vapeur comprenant un récipient comportant deux zones :
- une zone de production de vapeur (20) équipée d'un réceptacle pour le matériau et de moyens de chauffage du matériau placé dans le réceptacle ;
- une zone de diffusion communiquant avec la zone de production et équipée d'au moins un orifice (30) de telle sorte que le matériau en phase vapeur est transmis vers l'extérieur du récipient à travers l'orifice ;
ladite source de dépôt est **caractérisée par le fait que** :
- elle comprend des moyens d'obturation de l'orifice et des moyens de déplacement des moyens d'obturation entre une position obturée active et une position d'ouverture de l'orifice (30),
- elle présente une série d'orifices (30) sous la forme de buses diffusant la vapeur,
- la zone de diffusion consiste en un diffuseur (50) muni d'un corps cylindrique sur lequel les buses de diffusion sont placées côte à côte,
- les moyens d'obturation comprennent un manchon cylindrique (70) en contact avec la face interne du diffuseur (50), le manchon cylindrique (70) comprend d'une part plusieurs ouvertures (73) pouvant être positionnées en face de plusieurs buses de diffusion dans la position ouverte et, d'autre part, une ouverture en face de la zone de production de vapeur (71).

2. Source de dépôt selon la revendication précédente, dans laquelle le manchon cylindrique (70) est configuré de manière à se déplacer à l'intérieur du diffuseur (50) afin d'obturer la série de buses de diffusion tout en maintenant ouverte la zone de production de vapeur (20).

3. Source de dépôt selon la revendication précédente, dans laquelle des moyens de déplacement du manchon cylindrique (70) comprennent une tige axiale (72) réunie au manchon cylindrique (70) et accessible à travers le diffuseur (50).

4. Source de dépôt selon la revendication précédente, dans laquelle les moyens de déplacement du manchon cylindrique (70) comprennent un moyen de mise en rotation de la tige axiale (72).

5. Source de dépôt selon la revendication 3, dans laquelle les moyens de déplacement du manchon cylindrique (70) comprennent un moyen de translation latérale de la tige axiale (72).

6. Source de dépôt selon l'une quelconque des revendications précédentes, dans laquelle le diffuseur (50) inclut au moins une buse (53) qui s'ouvre indépendamment du déplacement du manchon cylindrique (70).

7. Source de dépôt selon l'une des revendications 3 à 5, dans laquelle au moins une buse indépendante (53) est placée dans l'axe du diffuseur (50) à l'extrémité opposée à la tige axiale (72).

8. Source de dépôt selon l'une quelconque des revendications précédentes, dans laquelle le réceptacle de matériau consiste en un creuset cylindrique (21), dont l'ouverture raccordée au diffuseur (50) présente un diamètre qui est identique au diamètre intérieur du manchon cylindrique (70).

9. Source de dépôt selon l'une quelconque des revendications précédentes, dans laquelle la zone de diffusion et la zone de production sont des cylindres tubulaires assemblés pour former un T, dont la zone de production est la branche centrée sur la branche formant le diffuseur (50).

10. Source de dépôt selon l'une quelconque des revendications précédentes, dans laquelle les moyens d'obturation sont configurés de manière à maintenir la connexion entre la zone de diffusion et la zone de production lorsque l'orifice (30) est ouvert.
